# EUROPEAN PATENT SPECIFICATION

(11) **EP 0 724 768 B1**
(45) Date of publication and mention of the grant of the patent: **14.11.2001**
(21) Application number: 95905293.7
(22) Date of filing: 17.10.1994
(51) Int. Cl.: H01J 17/16, H01J 61/12, H01J 61/30, H01J 65/04

(54) **TELLURIUM LAMP**
TELLURLAMPE
LAMPE A TELLURE

(30) Priority: 15.10.1993 US 136078
(43) Date of publication of application: 07.08.1996
(73) Proprietor: FUSION LIGHTING, INC., Rockville, MD 20855 (US)
(72) Inventor: TURNER, Brian, Myersville, MD 21773 (US)
(74) Representative: Schwepfinger, Karl-Heinz, Dipl.-Ing.
(86) International application number: PCT/US94/11770
(87) International publication number: WO 95/10847

(56) References cited:
- WO-A-92/08240
- US-A- 4 247 798
- US-A- 4 501 993
- US-A- 4 507 587
- DATABASE WPI Section Ch, Week 7711 Derwent Publications Ltd., London, GB; Class L03, AN 77-18775Y XP002107571 & JP 52 012791 A (MATSUSHITA ELECTRONICS CORP), 31 January 1977

## Description

The present invention is directed to a discharge lamp as definded in the precharacterized portion of claim 1.

The incandescent and fluorescent lamps which are commonly used in homes and offices, do not provide enough illumination for many commercial and industrial applications. Insofar as residential use is concerned, the incandescent lamp is lacking in efficacy (visible light output power as compared with inputted electrical power) and is therefore expensive to operate, while the fluorescent lamp does not provide a continuous spectrum.

The lamp which has gained acceptance and which is typically used for high power illumination for commercial and industrial applications is known as the high intensity discharge (HID) lamp. The fill in the HID lamp usually contains mercury. However, this is undesirable because mercury is a highly toxic and volatile substance. Thus, if a HID lamp should break, dangerous mercury fumes would be emitted, and after the useful life of the lamp is over, there is no easy way to safely dispose of the mercury containing envelope. The widespread use of mercury containing lamps has been recognized as a serious environmental problem.

There are many ways to measure how good a lamp is, and amongst those skilled in the lamp art the use of various standardized performance indicators has arisen. These include the luminous efficacy of the lamp, its rated life, lumen maintenance, chromaticity, and color rendering index (CRI). Additionally, the stability of the color of the light which is emitted by the lamp is important, as this may change over time. The closer these accepted indicators are to ideal, the better the performance of the lamp.

In accordance with the present invention, a lamp is provided which has superior performance characteristics, and which is also capable of operating without the use of mercury

In accordance with the invention, a lamp as defined in the precaracterizing portion of claim 1, is provided which has the features of the characterizing portion of claim 1.

The lamps which are provided in accordance with the present invention, have relatively high efficacy, good color rendition, relatively long life and output a continuous spectrum. Such lamps may also have high lumen maintenance as well as stable color output over time. Lamps having such characteristics are considered to be desirable light sources for a variety of visible lighting applications.

While it is known to use each of the elements of the periodic table (including tellurium) as the fill for a lamp so as to generate the atomic and/or molecular spectrum of such elements, such spectroscopic reference lamps do not provide either enough light or the correct spectrum for use as visible illumination sources.

It is thus an advantage of the present invention to provide a visible light source having superior performance.

The invention will be better appreciated in accordance with the accompanying figures, wherein:

Figure 1 is a perspective view of an embodiment of the invention.

Figure 2 is a side view of the embodiment of Figure 1.

Figure 3 is a further embodiment of the invention.

Figure 4 is a spectrum of emitted light for a tellurium lamp.

Figure 5 is a spectrum of emitted light for a selenium lamp to which tellurium has been added.

Figure 6 is a spectrum of emitted light for a selenium lamp.

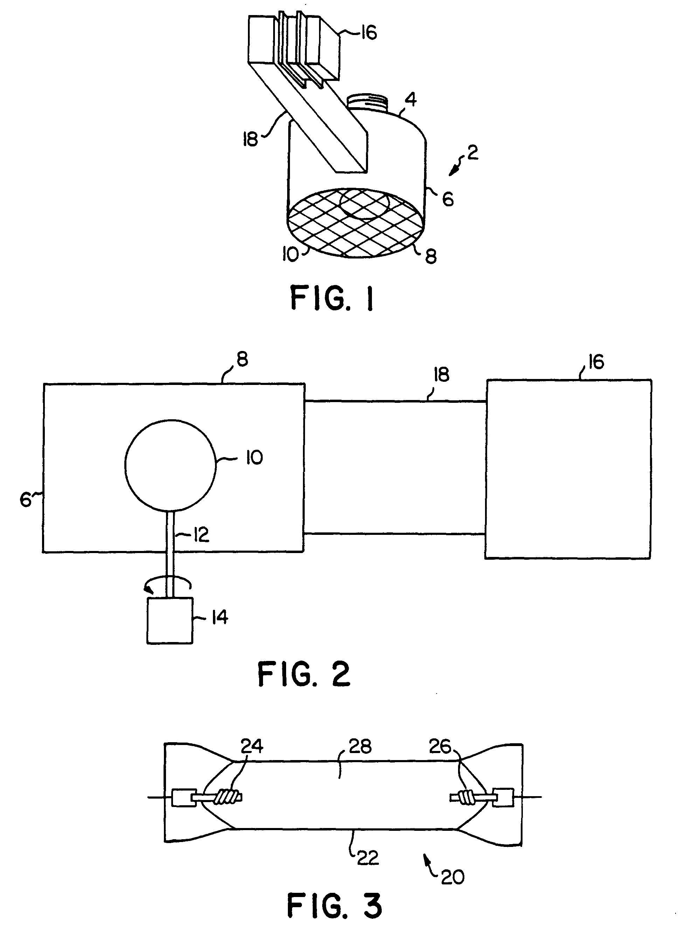

Referring to Figure 1, lamp 2 is depicted which is an embodiment of the invention which is powered by microwave energy, it being understood that R.F. energy may be used as well.

Lamp 2 includes a microwave cavity 4 which is comprised of metallic cylindrical member 6 and metallic mesh 8. Mesh 8 is effective to allow the light to escape from the cavity while retaining the microwave energy inside.

Bulb 10 is disposed in the cavity, which in the embodiment depicted is spherical. Referring to Figure 2, the bulb is supported by stem 12, which is connected with motor 14 for effecting rotation of the bulb. This rotation promotes stable operation of the lamp.

Microwave energy is generated by magnetron 16, and waveguide 18 transmits such energy to a slot (not shown) in the cavity wall, from where it is coupled to the cavity and particularly to the fill in bulb 10.

Bulb 10 consists of a bulb envelope and a fill in the envelope. In accordance with an aspect of the invention, tellurium or a tellurium compound from which elemental tellurium can be obtained upon excitation is included in the lamp fill in an amount which is sufficient so that when the fill is excited with sufficient power in operation, it emits visible radiation, with substantially all of the radiation resulting from the elemental tellurium being provided at wavelengths which are in excess of about 400 nm.

Tellurium compounds which may be used in the unexcited fill include TeO, TeS, TeSe, and tellurium halides including TeCl₅, TeBr₅ and TeI₅. Additional tellurium compounds which may be used are those which have a sufficiently low vapor pressure at room temperature, i.e., are a solid or a liquid, and which have a sufficiently high vapor pressure at operating temperature to provide useful illumination.

In order to provide enough tellurium containing substance to result in a lamp output in which the visible radiation emitted exceeds the ultraviolet, the average number density over the volume of the envelope of the tellurium is preferably at least about 10¹⁷ molecules/cc. That is, if elemental tellurium is used, this refers to the number density of the elemental tellurium, while if a tellurium compound is used, it refers to the number density of the compound.

The microwave or R.F. powered lamps described herein may be operated at a variety of power densities, for example those between about 5 watts/cc and a thousand or more watts/cc, it being understood that the power must be sufficient to vaporize the tellurium fill and create a pressure which results in the emission of radiation therefrom, substantially all of which is in excess of about 400 nm. The particular power density which is used in any application will depend upon the amount of tellurium fill used, the size of the bulb, and the required lumen output of the lamp.

Lamps for providing visible radiation which utilize sulfur and/or selenium based fills are known, and are described in U.S. Application No. 071,027, filed June 3, 1993 and PCT Publication No. WO 92/08240. It has been found, in accordance with an aspect of the present invention, that a beneficial effect is provided if tellurium is added to the fill of such a lamp.

More specifically, the addition of tellurium has the effect of shifting the spectral output of the lamp towards the red region, thus providing light which appears warmer to the eye, and which has a better color rendition.

In general, the ratio of the number density of the tellurium to the number density of the sulfur or selenium should not exceed 10%, while at the lower end, the ratio may be as small as a fraction of a percent. The tellurium may be added to the fill either in the form of elemental tellurium, or as a tellurium compound.

Additionally, the spectral output of a lamp in accordance with the invention may be controlled by combining tellurium, sulfur, and/or selenium in the fill in varying amounts.

The lamp fills described herein typically include a starting gas such as argon, xenon, or krypton. Also, the fills may include a variety of additives for various reasons, e.g., metal halides or other substances to emphasize particular regions of the spectrum. Additionally, while the lamp of the invention is capable of operating without mercury in the fill, the addition of mercury, in those applications where it can be tolerated, may enhance efficiency.

A further embodiment of the invention is shown in Figure 3. This is an arc lamp 20 which is comprised of quartz envelope 22 having electrodes 24 and 26, and containing fill 28. To excite the fill, an A.C. voltage is impressed across the electrodes, whereupon an arc discharge occurs therebetween.

The fill in envelope 22 is as described hereinabove for the electrodeless lamp embodiments, while the lamp may typically be excited at normal power densities for metal halide arc lamps. The electrodes 22 and 24 may be made of or plated with a special material such as platinum to prevent or minimize chemical reactions with the fill gas.

### Example I

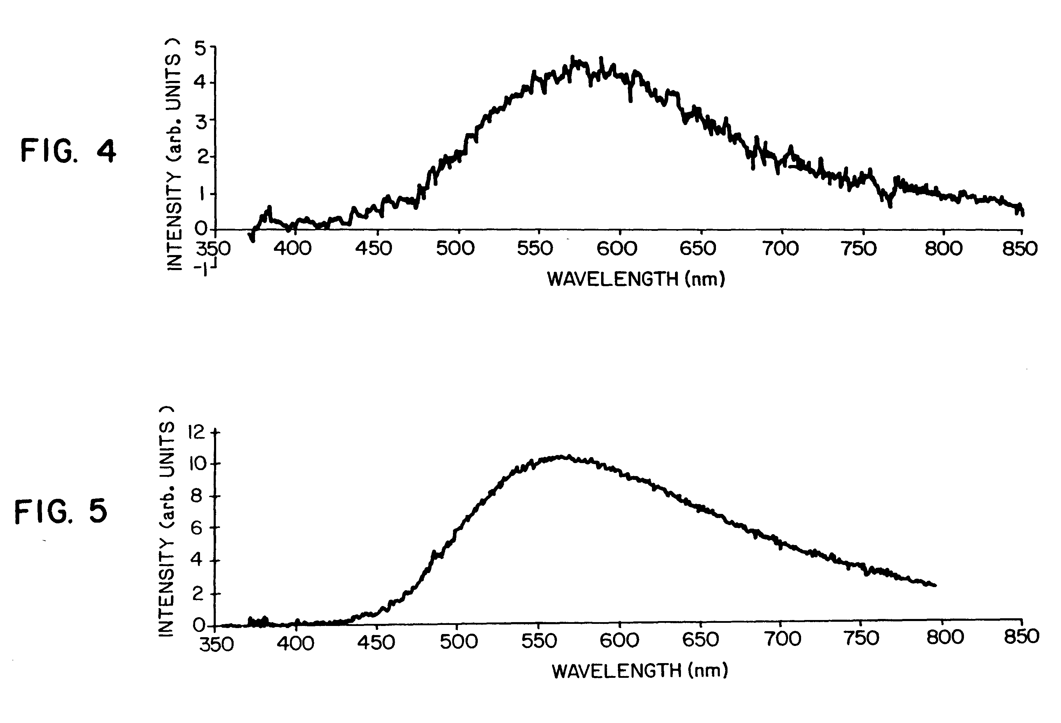

An actual lamp was built in accordance with the invention as follows. A 40 mm outer diameter (OD) (37 mm ID) spherical envelope was filled with 20 mg of Te and 13.3kPa (100 Torr) Xe, and powered by 1100 watts of microwave power in a resonant cavity. The spectral output of the emitted light is shown in Figure 4, and is seen to be a continuous, molecular spectrum, which results in light having a pleasant quality. The lamp efficacy was about 105 lumens/watt.

### Example II

A spherical envelope of 40 mm OD (37 mm ID) was dosed with 35 mg of Se, 5 mg of Te, and 13.3kPa (100 torr) of Xe. The lamp was excited with 1000 watts of microwave power in a resonant cavity. The spectral output is depicted in Figure 5. The efficacy is about 175 watts/cc.

### Comparison (Example II)

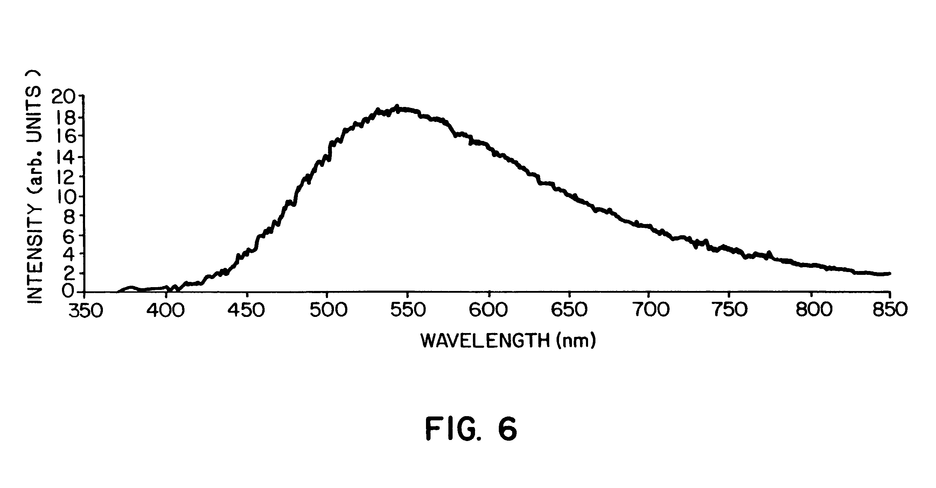

A spherical envelope of 40 mm OD (37 ID) was dosed with 34 mg of Se and 40kPa (300 torr) of Xe and excited with 1000 watts of microwave power in a resonant cavity. The spectral output is depicted in Figure 6.

A comparison of the spectra depicted in Figures 5 and 6 reveals that the spectrum of Figure 5, which was produced by a selenium lamp with tellurium added is shifted significantly towards the red region as compared with the spectrum of Figure 6, which was produced with a lamp having a selenium only fill. The light emitted by the lamp of Figure 5 has a warmer quality, and provides improved color rendition.

It is noted that the abcissas of the graphs of Figures 4, 5, and 6 are wavelength in nanometers (nm), while the ordinates are intensity in arbitrary units.

## Claims

1. A discharge lamp, comprising:
a lamp bulb (10, 22) having an envelope of light transmissive material;
a fill disposed in the envelope; and
means (2, 20) for exciting the fill,
wherein a radiating component is present in the fill in an amount such that when the fill is excited with sufficient power in operation the radiating component emits visible radiation with substantially all of the radiation from the radiating component being molecular radiation emitted at wavelengths longer than about 400 nm; **characterized in that**
said radiating component is elemental tellurium which is obtained upon excitation from a tellurium containing substance included in the fill.

2. The discharge lamp of claim 1, wherein the fill further includes a starting gas.

3. The discharge lamp of claim 1, wherein the lamp bulb (10) is electrodeless and the means (2) for exciting the fill applies microwave or R.F. power to the fill.

4. The discharge lamp of claim 1, wherein the number density of the tellurium containing substance is at least 10^{**17**} molecules/cc.

5. The discharge lamp of claim 1, wherein the lamp bulb (22) includes electrodes (24, 26) and the means (20) for exciting the fill applies an AC voltage across the electrodes.

6. The discharge lamp of claim 1, wherein the fill further includes an additive for emphasizing a particular spectral region.

7. The discharge lamp of claim 1, wherein the fill further includes sulfur in an amount sufficient for the sulfur to produce visible radiation during operation primarily from said sulfur.

8. The discharge lamp of claim 1, wherein the fill further includes selenium in an amount sufficient for the selenium to produce visible radiation during operation primarily from said selenium.

## Patentansprüche

1. Entladungslampe mit:
einem Lampenkolben (10, 22) mit einer Hülle aus lichtdurchlässigem Material;
einer in der Hülle angebrachten Füllung; und
ein Mittel (2, 20) zum Erregen der Füllung,
wobei in der Füllung eine strahlende Komponente in einer solchen Menge vorhanden ist, daß dann, wenn die Füllung im Betrieb mit ausreichender Energie erregt wird, die strahlende Komponente sichtbare Strahlung abgibt, wobei im wesentlichen die gesamte Strahlung von der strahlenden Komponente eine Molekularstrahlung ist, die mit Wellenlängen länger als etwa 400 nm abgegeben wird;
**dadurch gekennzeichnet, daß** die strahlende Komponente elementares Tellur ist, das bei Erregung aus einer tellurhaltigen Substanz erhalten wird, die in der Füllung enthalten ist.

2. Entladungslampe nach Anspruch 1, bei der die Füllung ferner ein Startgas enthält.

3. Entladungslampe nach Anspruch 1, bei der der Lampenkolben (10) elektrodenlos ist und das Mittel zum Anregen der Füllung Mikrowellen- oder HF-Energie an die Füllung anlegt.

4. Entladungslampe nach Anspruch 1, bei der die Dichte der tellurhaltigen Substanz wenigstens 10¹⁷ Moleküle/cc beträgt.

5. Entladungslampe nach Anspruch 1, bei der der Lampenkolben (22) Elektroden (24, 26) enthält und das Mittel (20) zum Anregen der Füllung eine Wechselspannung an die Elektroden anlegt.

6. Entladungslampe nach Anspruch 1, bei der die Füllung ferner einen Zusatzstoff zum Verstärken eines bestimmten Spektralbereichs enthält.

7. Entladungslampe nach Anspruch 1, bei der die Füllung ferner Schwefel in einer für den Schwefel ausreichenden Menge enthält, damit während des Betriebs in erster Linie aus dem Schwefel sichtbare Strahlung erzeugt wird.

8. Entladungslampe nach Anspruch 1, bei der die Füllung ferner Selen in einer für das Selen ausreichenden Menge enthält, damit während des Betriebs in erster Linie aus dem Selen sichtbare Strahlung erzeugt wird.

## Revendications

1. Lampe à décharge comprenant
une ampoule de lampe (10, 22) possédant une enveloppe de matériau translucide ;
un remplissage disposé dans l'enveloppe ; et
des moyens (2, 20) permettant d'exciter le remplissage,
dans lequel un composant rayonnant se trouve dans le remplissage dans une quantité telle que le remplissage est excité avec une puissance de fonctionnement suffisante pour que le composant rayonnant émette un rayonnement visible, sensiblement tout le rayonnement du composant rayonnant étant un rayonnement moléculaire émis à des longueurs d'onde supérieures à environ 400 nm ; **caractérisée en ce que**
ledit composant rayonnant est du tellure élémentaire qui est obtenu par excitation depuis une substance contenant du tellure, inclue dans le remplissage.

2. Lampe à décharge selon la revendication 1, dans laquelle le remplissage contient en outre un gaz de démarrage.

3. Lampe à décharge selon la revendication 1, dans laquelle l'ampoule de lampe (10) est sans électrode, et les moyens (2) pour exciter le remplissage appliquent au remplissage une puissance à micro-ondes ou à radiofréquence.

4. Lampe à décharge selon la revendication 1, dans laquelle la densité de la substance contenant du tellure est d'au moins 10¹⁷ molécules/cc.

5. Lampe à décharge selon la revendication 1, dans laquelle l'ampoule de lampe (22) contient des électrodes (24, 26) et les moyens (20) d'excitation du remplissage applique une tension alternative à travers les électrodes.

6. Lampe à décharge selon la revendication 1, dans laquelle le remplissage contient en outre un additif pour accentuer une zone spectrale particulière.

7. Lampe à décharge selon la revendication 1, dans laquelle le remplissage contient en outre du soufre en quantité suffisante pour que le soufre produise un rayonnement visible pendant l'opération, provenant en premier lieu dudit soufre.

8. Lampe à décharge selon la revendication 1, dans laquelle le remplissage contient en outre du sélène en quantité suffisante pour que le sélène produise un rayonnement visible pendant l'opération, provenant en premier lieu dudit sélène.
